Europäisches Patentamt

European Patent Office

Office européen des brevets

(19)

(11) Publication number: **0 117 645 B1**

(12) # EUROPEAN PATENT SPECIFICATION

(45) Date of publication of patent specification: **02.05.91**   (51) Int. Cl.⁵: **G11C 7/00, G11C 11/409**

(21) Application number: **84300556.2**

(22) Date of filing: **30.01.84**

(54) **Semiconductor memory device with transfer means between bit lines and data buses.**

(30) Priority: **31.01.83 JP 12987/83**

(43) Date of publication of application:
**05.09.84 Bulletin 84/36**

(45) Publication of the grant of the patent:
**02.05.91 Bulletin 91/18**

(84) Designated Contracting States:
**DE FR GB**

(56) References cited:
**EP-A- 0 048 464**
**US-A- 4 250 412**

**IBM TECHNICAL DISCLOSURE BULLETIN, vol. 19, no. 7, December 1976, pages 2482-2483, New York, US; L.M. ARZUBI: "Twin cell, high performance write circuit"**

**The Semiconducteur Memory Book, pages 22 to 25, Intel Marketing Communications, 1978, ISBN 0-471-03567-X**

(73) Proprietor: **FUJITSU LIMITED**
**1015, Kamikodanaka Nakahara-ku**
**Kawasaki-shi Kanagawa 211(JP)**

(72) Inventor: **Baba, Fumio**
**Miyamaedaira Gurin-haitsu 48-303 430**
**Mukogaoka**
**Miyamae-ku Kawasaki-shi Kanagawa 213(JP)**
Inventor: **Mochizuki, Hirohiko**
**2393-1-401 Arima Miyamae-ku**
**Kawasaki-shi Kanagawa 213(JP)**
Inventor: **Miyahara, Hatsuo**
**Dai 2 Yayoi-so 8 3-5-2 Shimoshinjo**
**Nakahara-ku**
**Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

## Description

The present invention relates to a semiconductor memory device, more particularly to a semiconductor memory device provided with two separate circuits used during write and read operations, respectively, as a data transfer means between bit lines and data buses.

In a semiconductor memory device, for example, a dynamic random access memory (DRAM) comprising matrix-arranged memory cells, the memory cells are connected at the cross points of word lines and bit lines. Row selection of the memory cells is performed by selection of a word line. Column selection of the memory cells is performed by selection of a pair of bit lines in response to the output of a column decoder. Each bit line pair is connected to a sense amplifier. To each side of each sense amplifier to which the pairs of bit lines are connected, a dummy cell is connected. In reading the memorized data, when one of the right-side memory cells is selected, the left-side dumb cell is selected. When any one of the left-side memory cells is selected, the right-side dummy cell is selected. The dummy cell provides a reference potential during the read operation from the memory cell.

Between each bit line and one of a pair of data buses, a transfer gate is connected as a data transfer means. The signal read out from the memory cell connected to the selected word line is transferred to the pair of bit lines, amplified by the sense amplifier, and supplied to the data buses through the transfer gates. In write operations, the writing data signals supplied from the data buses, which are usually in the form of complementary signals, are transferred to the bit lines through the transfer gates and one of the selected data signals is written into the selected memory cell. In the last part of the read operation period in most practical DRAM's, the bit lines are driven by a buffer circuit which is connected to the data buses to provide amplified output signals. That is, a rewrite operation is performed via the transfer gates to retrieve the necessary bit line potential which has been lost during the preceding part of the read operation period for driving the data buses. However, it is desirable to prevent the data memorized in the memory cells from destruction, even if the read operation is stopped halfway. Such an interruption of the read operation should be permitted, to facilitate the timing design of a system using the memory device. In the case where the semiconductor memory device enters a precharge mode before completing the rewrite operation, the potential on the bit line, which has been changed due to redistribution of electric charges via the transfer gate between the bit lines and the data buses, is memorized in the selected memory cell. This results in possible destruction of the memorized data in the memory cell.

A static semiconductor memory employing separate transfer means between bit lines and data lines for reading and writing, respectively, is disclosed in "THE SEMICONDUCTOR MEMORY BOOK", published by Intel Marketing communications in 1978, on pages 22 to 25. In this memory, the transfer means for reading has a high input impedance and a low output impedance.

According to the present invention, there is provided a dynamic semiconductor memory device comprising: a word line, a pair of bit lines, a memory cell connected to said word line and one of said bit lines, a pair of data buses, a sense amplifier connected to said pair of bit lines, a first transfer means connected between said pair of bit lines and said pair of data buses for transferring data from the data buses to the bit lines in a write operation, and a second transfer means having a high impedance input and a low impedance output connected between said pair of bit lines and said pair of data buses for transferring data from the bit lines to the data buses in a read operation whilst minimising a change in the potential of the bit lines.

An embodiment of the present invention can provide a semiconductor memory device, wherein data memorized in a memory cell is not destroyed even if the data read operation stops midway due to a system reset or the like.

Use of the device prevents redistribution of electric charges from causing fluctuation of the potential of the bit line to a middle level during a read operation. Therefore, even if a system reset occurs at any time in the read operation, the data in the memory cell is not destroyed. As a result, the semiconductor memory device facilitates the timing design of the system because it does not impose any restriction upon the system as to the timing of the termination of the read access.

Reference is made, by way of example, to the accompanying drawings in which:

Figure 1 is a partial block circuit diagram of a conventional semiconductor memory device;

Fig. 2 is a waveform diagram for explaining the operation of the device of Fig. 1;

Fig. 3 is a partial block circuit diagram of a semiconductor memory device according to an embodiment of the present invention; and

Fig. 4 is a waveform diagram for explaining the operation of the device of Fig. 3.

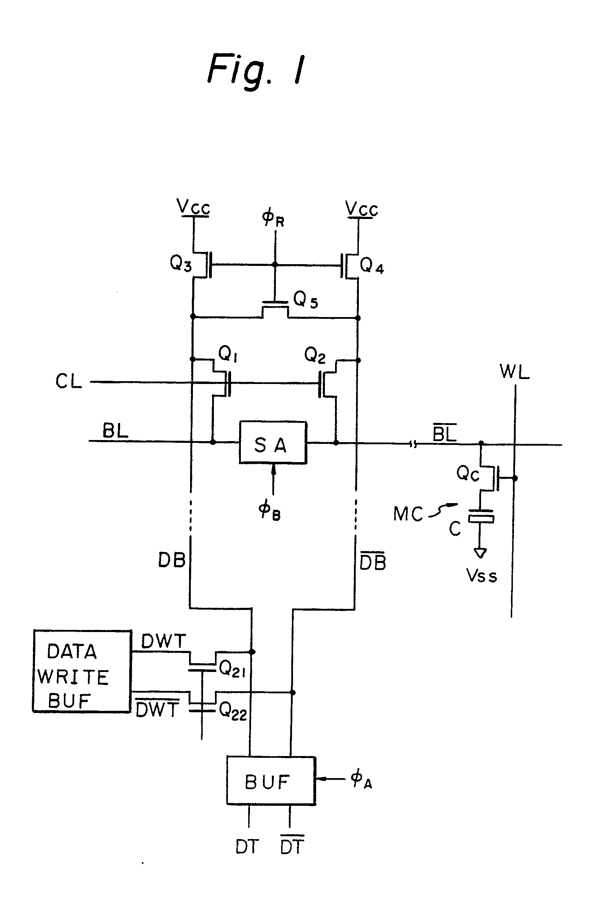

Prior to describing an embodiment of the present invention, an explanation of a conventional DRAM will be given with reference to Fig. 1 for comparative purposes.

The DRAM of Fig. 1 comprises a sense amplifier SA, a pair of bit lines BL and $\overline{BL}$ connected

to the sense amplifier SA, a pair of data buses DB and $\overline{DB}$, and transistors Q1 and Q2 connected between the bit line $\overline{BL}$ and the data bus $\overline{DB}$, respectively, as transfer gates. A memory cell comprising a transistor Qc and a capacitor C is connected between the bit line $\overline{BL}$ and a word line WL. Between one end of each of the data buses DB and $\overline{DB}$ and a power source Vcc, are connected transistors Q3 and Q4 for precharging the data buses for resetting the same, respectively. Also, between the data buses DB and $\overline{DB}$ is connected a transistor Q5 for equalizing the potentials of the buses during resetting. To the gates of transistors Q3, Q4, and Q5 for resetting is applied a reset clock $\emptyset_R$. To the other ends of the data buses DB and $\overline{DB}$ is connected a data buffer BUF. Of course, although Fig. 1 shows only one pair of bit lines BL and $\overline{BL}$, one word line, one sense amplifier SA, one pair of data buses DB and $\overline{DB}$, and the like, a plurality of these elements are actually provided.

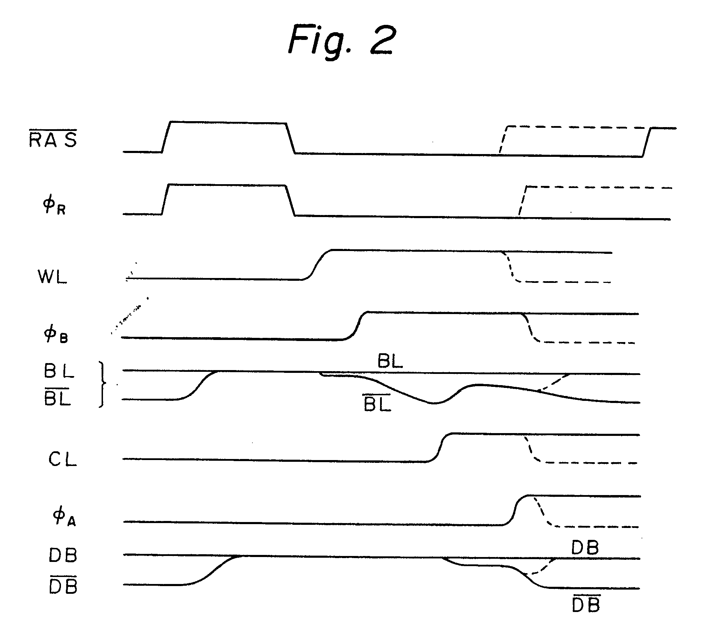

The operation of the DRAM in Fig. 1 will now be explained with reference to Fig. 2. The reset clock $\emptyset_R$ is made a high level during the reset or precharge period in which a row address strobe signal $\overline{RAS}$ applied to the memory device is a high level. This turns on all the transistors Q3, Q4, and Q5 and resets the potentials on the data buses DB and $\overline{DB}$ to a high level.

Next, the row address strobe signal $\overline{RAS}$ is made the low level to initiate the read or write operation, and a row address signal is applied to the row decoder to select one word line WL. As a result, when the selected word line WL becomes a high level, the transistor QC in the memory cell MC connected to the word line WL turns on so as to change the potential of the bit line $\overline{BL}$ from its precharge level through redistribution of electric charges between the cell MC and the bit line $\overline{BL}$.

Concurrently, a dummy cell (not shown) connected to the other bit line BL is selected to provide a potential change on the bit line BL which forms a reference level with respect to the potential of the opposite bit line $\overline{BL}$. Thus a potential difference is formed between the bit line pair BL and $\overline{BL}$ depending on the amount of charges stored in the memory cell MC.

Then, when a sense-amplifier enable clock $\emptyset_B$ applied to the sense amplifier SA becomes a high level, the potential difference between the bit lines BL and $\overline{BL}$ is enlarged (amplified) corresponding to the data in the memory cell MC. In the meantime, a column address signal is acquired in response to the falling of the column address strobe signal $\overline{CAS}$ to generate a column selection signal CL from a column decoder (not shown). When the potential difference between the bit lines BL and $\overline{BL}$ is enlarged sufficiently, the column selection signal CL applied to the gates of the transistors Q1 and Q2 becomes a high level and the transistors Q1 and Q2 are turned on. As a result, the signals on the bit lines BL and $\overline{BL}$ are transferred to the data buses DB and $\overline{DB}$, respectively, and an potential difference is generated between the data buses DB and $\overline{DB}$.

Then, a clock $\emptyset_A$ is made a high level to activate the data buffer BUF, which enlarges the potential difference between the data buses DB and $\overline{DB}$ and provides output read data to the exterior via data lines DT and $\overline{DT}$.

Now, when writing data into a memory cell MC, write signals are supplied to the data buses DB and $\overline{DB}$ from data write lines DWT and $\overline{DWT}$, from a data write buffer DATA WRITE BUF through data write control gates Q21 and Q22. The write signals are transferred to the pair of bit lines BL and $\overline{BL}$ through the transistors Q1 and Q2 used as transfer gates, and the data is written into the memory cell.

In the conventional DRAM of Fig. 1, if, during a data read operation, the DRAM enters a precharge mode in which the $\overline{RAS}$ signal is in a high level, there is a possibility of destruction of data in the memory cell. Namely, as shown in Fig. 2, after the sense-amplifier enable clock $\emptyset_B$ becomes a high level and the potential difference between the bit lines BL and $\overline{BL}$ is enlarged, the column selection signal CL becomes a high level and the bit lines BL and $\overline{BL}$ are connected to the data buses DB and $\overline{DB}$, respectively. As a result, redistribution of the electric charge occurs between the electrostatic capacitance of the bit line $\overline{BL}$ and the capacitor C and the electrostatic capacitance of the data bus $\overline{DB}$. The potential on the bit line $\overline{BL}$ therefore temporarily rises from a low level to a higher level.

In the last part of the normal read cycle, the potential difference is enlarged again by the data buffer BUF, which is basically comprised of a cross-coupled transistor pair for forming a latch circuit.

If, however, a processor or the like connected to the DRAM of Fig. 1 commands the DRAM to enter the precharge mode prior to the activation of the data buffer BUF by resetting the row address strobe signal $\overline{RAS}$ and the like, as shown by the broken line in Fig. 2, the potential on the word line WL becomes a low level, and the transistor Qc in the memory cell MC is cut off to confine the temporarily raised potential. Therefore, the capacitor C in the memory cell MC memorizes a potential having a medium level. Thus, there is a possibility of memorizing erroneous data.

Namely, in the conventional DRAM of Fig. 1, there is a disadvantage that resetting of the processor or the like connected to the DRAM may destroy the memorized data in the case where the period of the read cycle defined by the row address strobe signal $\overline{RAS}$ is shorter than a predetermined period.

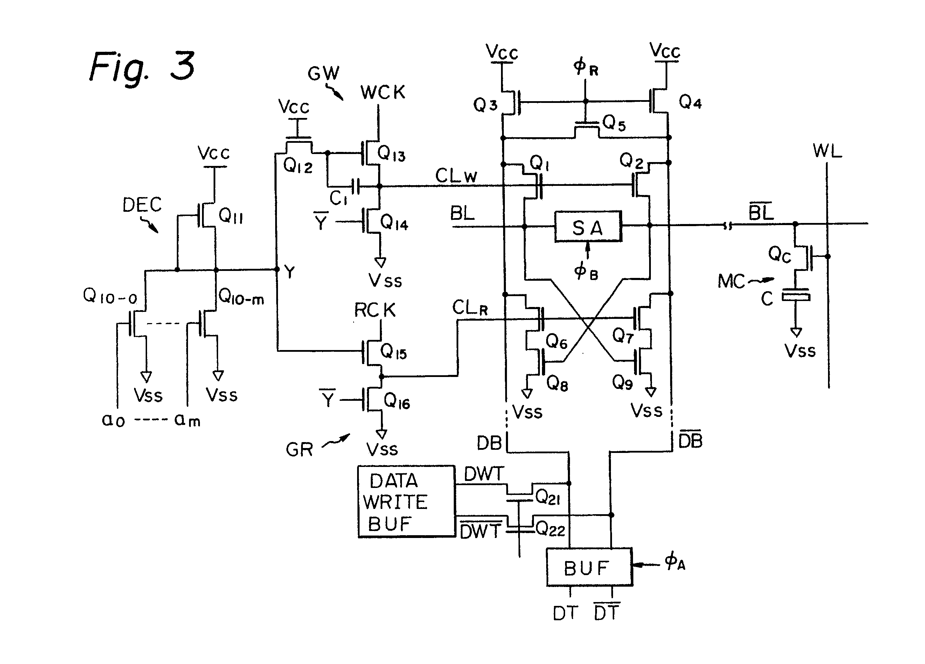

Hereinafter, a semiconductor memory device according to an embodiment of the present invention will be explained. Figure 3 shows a partial constitution of a DRAM of the semiconductor memory device. In Fig. 3, elements identical with the elements of Fig. 1 bear identical reference marks.

One of the important differences between the DRAM of Fig. 3 and that of Fig. 1 is that the former transfers data between the bit lines BL and $\overline{BL}$ and the data buses DB and $\overline{DB}$ using separate data transfer circuits during write and read operations. Namely, during a write operation, the transistor Q1 connecting the bit line BL and the data bus DB and the transistor Q2 connecting the bit line $\overline{BL}$ and the data bus $\overline{DB}$ are used. During a read operation, the data transfer means comprising the transistors Q6, Q7, Q8, and Q9 is used.

The transistors Q6 and Q8 are series-connected between the data bus DB and a power source Vss, for example, the ground, and the transistors Q7 and Q9 are series-connected between the data bus $\overline{DB}$ and the power source Vss. To the gates of the transistors Q6 and Q7 is applied a column selection signal $CL_R$ for reading. Also, the gates of the transistors Q8 and Q9 are connected to the bit lines $\overline{BL}$ and BL, respectively. To the gates of the transistors Q1 and Q2, as the transfer gates for writing, is applied a column selection signal $CL_W$ for writing.

The signal $CL_W$ is controlled by a write clock WCK and supplied from a writing gate circuit GW comprising transistors Q12, Q13, Q14, and a capacitor CI. The column selection signal $CL_R$ for reading is controlled by a read clock RCK and supplied from a reading gate circuit GR comprising transistors Q15 and Q16. A column decoder DEC comprises transistors Q10-0, ..., Q10-m to which m + l bits column address signals ao, ..., am are supplied, respectively, and a load transistor Q11. The column decoder DEC generates a column decode signal Y and supplies it to the gate circuits GW and GR. Also, the column decoder DEC comprises an inverter circuit (not shown), generates a signal $\overline{Y}$ inverting the signal Y, and applies the signal $\overline{Y}$ to predetermined transistors in the gate circuits GW and GR.

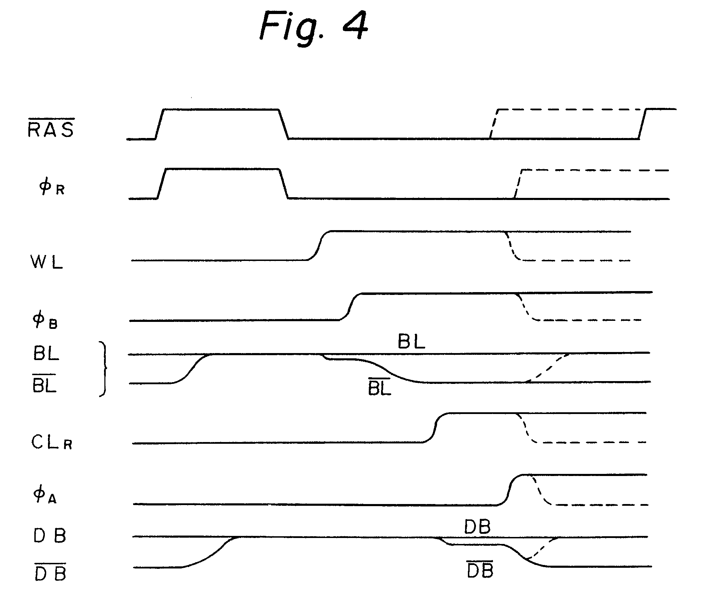

The operation of the DRAM of Fig. 3 is explained with reference to Fig. 4. In reading data from a selected memory cell MC, during the preceding reset or precharge period in which the row address strobe signal $\overline{RAS}$ supplied to the memory device from the exterior is a high level, the reset clock $\phi_R$ is in a high level, the transistors Q3, Q4, and Q5 are all in an on-state, and the potentials of the data buses DB and $\overline{DB}$ are reset to a high level. Also, the potentials of both the bit lines BL and $\overline{BL}$ are set to a high level by a precharge circuit (not shown). Then, when the row address strobe signal $\overline{RAS}$ falls down to a low level to initiate the read cycle, address signals then appearing at address input terminals of the memory device are captured as row address signals, which provide one selected word line with a selection signal through the row decoder. Next, the one word line WL selected by the row address signal becomes a high level, the transistor Qc in the memory cell MC is turned on, and the capacitor C is connected to the bit line $\overline{BL}$. Then, a sense-amplifier enable clock $\phi_B$ is made a high level and the sense amplifier SA is activated.

As a result, the potential difference between the bit lines BL and $\overline{BL}$ is enlarged, and, for example, the potential on the bit line $\overline{BL}$ is kept at a high level and the potential on the bit line BL is pulled down to a low level. Meanwhile, column address signals are obtained in response to falling of the column address strobe signal $\overline{CAS}$ in a similar manner and are applied to the column decoder to generate an output column decode signal. In this state, the output Y of the selected column decoder DEC and the read clock RCK become a high level, and the inverted column decode signal $\overline{Y}$ becomes a low level. Thus, the column selection signal $CL_R$ for reading becomes a high level.

As a result, the transistors Q6 and Q7 are turned on, and, since the bit line BL is a high level and the bit line $\overline{BL}$ is a low level, the transistor Q9 is turned on and the transistor Q8 is turned off. Therefore, the potential on the data bus $\overline{DB}$ is pulled down to a low level, and the potential on the data bus DB is held at a high level. In this state, the clock $\phi_A$ is made a high level, the data buffer BUF operates, and the output signal from the data buses DB and $\overline{DB}$ is sent out to the data line DT and $\overline{DT}$. By the above-mentioned operations, the read operation from the memory cell is carried out. Since the data transfer transistors Q8 and Q9 perform inversion of data, the bit line pair BL and $\overline{BL}$ are cross-coupled to these transistors Q8 and Q9 to maintain the coincidence of the written data and read out data.

In performing such a read operation, in the DRAM of Fig. 3, the potentials of the data buses DB and $\overline{DB}$ are controlled with the potentials of the bit lines BL and $\overline{BL}$ through the gates of the transistors Q9 and Q8. The bit lines BL and $\overline{BL}$ are not directly connected to the data buses DB and $\overline{DB}$ through the transfer gate circuits, therefore, no redistribution of electric charge occurs between bit lines and data buses and, when the column selection signal $CL_R$ for reading is a high level, the potential of the bit lines is prevented from fluctuating to the neutral level (or middle level between high and low level).

Namely, as shown in Fig. 4, for example, the potential on the bit lines BL remains at a high level, and the potential on the bit line $\overline{BL}$ can be maintained at a low level. Thus, even if the DRAM enters the reset or precharge mode midway in the read operation, as shown with the broken lines in Fig. 4, no erroneous data is rewritten into the memory cell MC. In addition, in Fig. 4, the potential of the bit line $\overline{BL}$ rises to a high level after system resetting, as shown with a broken line. Since, however, the row address strobe signal $\overline{RAS}$ has already become a high level and the word line WL has become a low level, the transistor Qc is cut off, and the capacitor C in the memory cell MC is separated from the bit line $\overline{BL}$. Therefore, there is no possibility of writing erroneous data into the memory cell MC.

When writing data into the memory cell MC using the DRAM of Fig. 3, write data supplied to the data buses DB and $\overline{DB}$ from data write lines DWT and $\overline{DWT}$ through data write control gates Q21 and Q22 are transferred to the bit lines BL and $\overline{BL}$ through the transistors Q1 and Q2. At this time, both the decoded output Y of the column decoder DEC and the write clock WCK become a high level, and the inverted decode signal $\overline{Y}$ becomes a low level. This results in the column selection signal $CL_W$ for writing becoming a high level and the transistors Q1 and Q2 being turned on.

In the above embodiment each column comprising a pair of bit lines is provided with a set of a column decoder DEC and gate circuits GW and GR. However, it is possible to modify this constitution so that only one set of circuits DEC, GW and GR is provided for a plurality of columns by adding a column selection means.

For example, if two data bus pairs are provided along the sense amplifiers which are alternately connected thereto, only one set of the column control circuits DEC, GW and GR need be provided for two columns to control the two columns in common. The number of necessary column decoders can be further decreased by using different column selection means, for example, column selection lines and selection gates, so that plural pairs of gate circuits GW and GR are driven by a common decoder output through the selection gates. In these modifications, however, still one set of write transfer gates Q1 and Q2 and read transfer gate circuits Q6 to Q9 should be provided per each bit line pair.

**Claims**

1. A dynamic semiconductor memory device comprising:
   a word line (WL),
   a pair of bit lines (BL,$\overline{BL}$),
   a memory cell (MC) connected to said word line (WL) and one of said bit lines ($\overline{BL}$),
   a pair of data buses (DB,$\overline{DB}$),
   a sense amplifier (SA) connected to said pair of bit lines (BL,$\overline{BL}$),
   a first transfer means connected between said pair of bit lines (BL,$\overline{BL}$) and said pair of data buses (DB,$\overline{DB}$) for transferring data from the data buses (DB,$\overline{DB}$) to the bit lines (BL,$\overline{BL}$) in a write operation, and
   a second transfer means having a high impedance input and a low impedance output connected between said pair of bit lines (BL,$\overline{BL}$) and said pair of data buses (DB,$\overline{DB}$) for transferring data from the bit lines (BL,$\overline{BL}$) to the data buses (DB,$\overline{DB}$) in a read operation whilst minimising a change in the potential of the bit lines (BL,$\overline{BL}$) during a read operation.

2. A semiconductor memory device as set forth in claim 1, wherein said second transfer means comprises a pair of first transistors (Q8,Q9), each of said first transistors (Q8,Q9) having a gate operatively connected to one of the bit line pair (BL,$\overline{BL}$) and being operatively connected to the other corresponding one of the data bus pair (DB,$\overline{DB}$) to control its potential in response to the potential of said one of the bit line pair (BL,$\overline{BL}$).

3. A semiconductor memory device as set forth in claim 1 further comprising:
   a first means operatively connected to said first transfer means for providing a column selection signal ($CL_W$) for writing, and
   a second means operatively connected to said second transfer means for providing a column selection signal ($CL_R$) for reading.

4. A semiconductor memory device as claimed in claim 2, wherein the second transfer means further comprises a pair of second transistors (Q6,Q7), each second transistor (Q6,Q7) connected in series with one of said first transistors(Q8,Q9) so as to operatively connect each of said first transistors(Q8,Q9) to the other corresponding one of the data bus pair (DB,$\overline{DB}$), respectively.

5. A semiconductor memory device as claimed in claim 4, wherein the column selection signal ($CL_R$) for reading is applied to the gates of the second transistors (Q6,Q7) and the column selection signal ($CL_W$) for writing is applied to the first transfer means.

## Revendications

1. Dispositif de mémoire semiconducteur dynamique comprenant :
   une ligne de mots (WL),
   une paire de lignes de bits (BL, $\overline{BL}$ ),
   une cellule mémoire (MC) connectée à la ligne de mots (WL) et à une des lignes de bits ($\overline{BL}$ ),
   une paire de bus de données (DB, $\overline{DB}$ ),
   un amplificateur sélecteur (SA) connecté à la paire de lignes de bits (BL, $\overline{BL}$ ),
   un premier moyen de transfert connecté entre la paire de lignes de bits (BL, $\overline{BL}$ ) et la paire de bus de données (DB, $\overline{DB}$ ) pour transférer des données depuis les bus de données (DB, $\overline{DB}$ ) jusqu'aux lignes de bits (BL, $\overline{BL}$ ) lors d'une opération d'écriture, et
   un second moyen de transfert ayant une entrée à impédance élevée et une sortie à impédance faible connecté entre la paire de lignes de bits (BL, $\overline{BL}$ ) et la paire de bus de données (DB, $\overline{DB}$ ) pour transférer des données depuis les lignes de bits (BL, $\overline{BL}$ ) jusqu'aux bus de données (DB, $\overline{DB}$ ) lors d'une opération de lecture tout en minimisant une modification du potentiel des lignes de bits (BL, $\overline{BL}$ ) lors d'une opération de lecture.

2. Dispositif de mémoire semiconducteur selon la revendication 1, dans lequel le second moyen de transfert comprend une paire de premiers transistors (Q8, Q9), chacun de ces premiers transistors (Q8, Q9) ayant une grille connectée de manière opérationnelle à une des paires de lignes de bits (BL, $\overline{BL}$ ) et étant connecté de manière opérationnelle à l'autre des paires de bus de données correspondantes (DB, $\overline{DB}$ ) pour commander son potentiel en réponse au potentiel d'une des paires de lignes de bits (BL, $\overline{BL}$ ).

3. Dispositif de mémoire semiconducteur selon la revendication 1 comprenant en outre :
   un premier moyen connecté de manière opérationnelle au premier moyen de transfert pour fournir un signal de sélection de colonne (CL$_W$) pour l'écriture, et
   un second moyen connecté de manière opérationnelle au second moyen de transfert pour fournir un signal de sélection de colonne (CL$_R$) pour la lecture.

4. Dispositif de mémoire semiconducteur selon la revendication 2, dans lequel le second moyen de transfert comprend en outre une paire de seconds transistors (Q6, Q7), chaque second transistor (Q6, Q7) étant connecté en série avec un des premiers transistors (Q8, Q9) afin de connecter de manière opérationnelle chacun des premiers transistors (Q8, Q9) à l'autre des paires de bus de données correspondants (DB, $\overline{DB}$ ), respectivement.

5. Dispositif de mémoire semiconducteur selon la revendication 4, dans lequel le signal de sélection de colonne (CL$_R$) pour la lecture est appliqué aux grilles des seconds transistors (Q6, Q7) et dans lequel le signal de sélection de colonne (CL$_W$) pour l'écriture est appliqué au premier moyen de transfert.

## Ansprüche

1. Dynamische Halbleiterspeichervorrichtung mit:
   einer Wortleitung (WL),
   einem Paar von Bitleitungen (BL, $\overline{BL}$ ),
   einer Speicherzelle (MC), die mit der genannten Wortleitung (WL) und einer der genannten Bitleitungen ($\overline{BL}$ ) verbunden ist,
   einem Paar von Datenbussen (DB, $\overline{DB}$ ),
   einem Leseverstärker (SA), der mit dem genannten Paar von Bitleitungen (BL, $\overline{BL}$ ) verbunden ist,
   einer ersten Transfereinrichtung, die zwischen dem genannten Paar von Bitleitungen (BL, $\overline{BL}$ ) und dem genannten Paar von Datenbussen (DB, $\overline{DB}$ ) verbunden ist, um beim Schreibbetrieb Daten von den genannten Datenbussen (DB, $\overline{DB}$ ) zu den Bitleitungen (BL, $\overline{BL}$ ) zu übertragen, und
   einer zweiten Transfereinrichtung, die einen Eingang hoher Impedanz und einen Ausgang niedriger Impedanz hat und zwischen dem genannten Paar von Bitleitungen (BL, $\overline{BL}$ ) und dem genannten Paar von Datenbussen (DB, $\overline{DB}$ ) verbunden ist, um in einem Lesebetrieb Daten von den Bitleitungen (BL, $\overline{BL}$ ) zu den Datenbussen (DB, $\overline{DB}$ ) zu übertragen, während eine Änderung in dem Potential der Bitleitungen (BL, $\overline{BL}$ ) während eines Lesebetriebs minimiert wird.

2. Halbleiterspeichervorrichtung nach Anspruch 1, bei der die genannte zweite Transfereinrichtung ein Paar von ersten Transistoren (Q8, Q9) umfaßt, wobei jeder der genannten ersten Transistoren (Q8, Q9) ein Gate hat, das wirkungsmäßig mit einer Leitung des Bitleitungspaares (BL, $\overline{BL}$ ) und wirkungsmäßig mit dem anderen entsprechenden Bus des Datenbuspaares (DB, $\overline{DB}$ ) verbunden ist, um dessen Potential, ansprechend auf das Potential der genannten einen Leiter des Bitleitungspaares (BL, $\overline{BL}$ ), zu steuern.

3. Halbleiterspeichervorrichtung nach Anspruch 1, ferner mit:
einer ersten Einrichtung, die wirkungsmäßig mit der genannten ersten Transfereinrichtung verbunden ist, um ein Spaltenauswahlsignal ($CL_W$) zum Schreiben zu liefern, und
einer zweiten Einrichtung, die wirkungsmäßig mit der genannten zweiten Transfereinrichtung verbunden ist, um ein Spaltenauswahlsignal ($CL_R$) zum Lesen zu erzeugen.

4. Halbleiterspeichervorrichtung nach Anspruch 2, bei der die genannte zweite Transfereinrichtung ferner ein Paar von zweiten Transistoren (Q6), Q7) umfaßt, von denen jeder zweite Transistor (Q6, Q7) in Reihe mit einem der genannten ersten Tranistoren (Q8, Q9) so verbunden ist, daß er wirkungsmäßig jeden der genannnten ersten Transistoren (Q8, Q9) jeweils mit dem anderen entsprechenden Bus des Datenbuspaares (DB, $\overline{DB}$) wirkungsmäßig verbindet.

5. Halbleiterspeichervorrichtung nach Anspruch 4, bei der das Spaltenauswahlsignal ($CL_R$) zum Lesen den Gates der zweiten Transistoren (Q6, Q7) zugeführt wird, und das Spaltenauswahlsignal ($CL_W$) zum Schreiben der ersten Transfereinrichtung zugeführt wird.

# Fig. I

Fig. 2

Fig. 3

# Fig. 4

EP 0 117 645 B1